# EUROPEAN PATENT SPECIFICATION

(11) **EP 0 301 468 B1**
(45) Date of publication and mention of the grant of the patent: **25.08.1993**
(21) Application number: 88112002.6
(22) Date of filing: 26.07.1988
(51) Int. Cl.: H01L 21/82, H01L 21/285, H01L 27/08

(54) **Process for fabricating complementary contactless vertical bipolar transistors**
Verfahren zum Herstellen komplementärer kontaktloser vertikaler Bipolartransistoren
Procédé pour fabriquer des transistors bipolaires du type complémentaire vertical sans contact

(30) Priority: 29.07.1987 US 79626
(43) Date of publication of application: 01.02.1989
(73) Proprietor: FAIRCHILD SEMICONDUCTOR CORPORATION, Santa Clara California 95052 (US)
(72) Inventor: Vora, Madhukar B., Los Gatos California 95303 (US)
(74) Representative: Sparing Röhl Henseler Patentanwälte

(56) References cited:
- EP-A- 0 001 586
- FR-A- 2 300 417
- US-A- 3 909 318
- US-A- 4 005 453
- US-A- 4 038 680

## Description

This invention relates to integrated circuit fabrication processes, and more particularly to a method of providing complementary contactless vertical bipolar transistors.

Recent developments in contactless bipolar transistor technology make possible smaller bipolar devices with simplified interconnect structures, thereby reducing power consumption and increasing yield. These developments include the use of polysilicon for the emitter structure, which permits the fabrication of extremely shallow emitters; the use of composed masking, in which critical spacings between the base and emitter are defined in the polysilicon at the same mask level; the use of polysilicide instead of the conventional copper-doped aluminum for emitter interconnect, which provides thin reliable current carriers; and the use of a high degree of self-alignment, by which, for example, the polysilicide covering the base, emitter and collector regions is aligned to the polysilicon features, and the n+ polysilicon is aligned to the emitter.

The developments recited above are described in US-A-4,609,568, issued September 2, 1986 to Koh et al., which teaches a process for fabricating self-aligned regions of metal silicide on bipolar integrated circuits having self-aligned polysilicon emitter and base contacts. Polysilicon is deposited on the silicon substrate, then suitably doped and coated with a layer of protective nitride. After a process sequence involving an oxidation mask (also known in the art as a silicide exclusion mask) and a poly definition mask, base, emitter and collector contacts are formed in the polysilicon, and polysilicon areas from which silicide is to be excluded are defined. Subsequently, (a) a thermal drive-in step forms a base and emitter self-aligned to their respective polysilicon contacts; and (b) a thermal oxidation step passivates the active areas and form an oxide over areas from which silicide is to be excluded, whereby a self-aligned silicide can be formed over all exposed poly.

Unfortunately, the need remains for a bipolar process that provides either vertical NPN transistors, vertical PNP transistors, or both while retaining the advantages of a poly emitter, composed poly definition mask, silicide interconnect system, and self-aligned features, all without involving an excessive number of masking steps.

U.S-A-3 909 318 discloses also an island technique to obtain complementary transistors, but no vertical structures are described therein.

An object of the present invention is to provide a single process suitable for forming NPN contactless vertical transistors, PNP contactless vertical transistors, or both.

This and other objects are achieved by the sequence of process steps and the structure defined in claims 1 and 9, respectively. A particular embodiment of the invention is summarized below in Table 1. The columns marked "NPN Devices" and "PNP Devices" describe the purpose for the masking step in the fabrication of the respective devices.

**TABLE 1**

| Mask | NPN Devices | PNP Devices |
|---|---|---|
| 1 | Buried Layer & P- Tub | -- |
| 2 | Channel Stopper | Buried Layer |
| 3 | Isolation Oxide | Isolation Oxide |
| 4 | Sink | Ground |
| 5 | Base (NPN only) | Sink |
| 6 | -- | Base (PNP only) |
| 7 | N+ Poly Implant (NPN emitter) | N+ Poly Implant (PNP extrinsic base) |
| 8 | P+ Poly Implant (NPN extrinsic base) | P+ Poly Implant (PNP emitter) |
| 9 | Poly Definition | Poly Definition |
| 10 | Silicide Exclusion (for resistor & diode) | Silicide Exclusion (for resistor & diode) |
| 11 | Contact | Contact |
| 12 | First Metal | First Metal |
| 13 | Via | Via |
| 14 | Second Metal | Second Metal |
| 15 | Scratch Protection | Scratch Protection |

Excellent quality NPN transistors can be produced without masking step number 6; hence, the process for forming both NPN and PNP transistors requires only one additional masking step. In addition to masking step number 6, the complementary bipolar process of the present invention includes two additional implants beyond that required for the NPN process alone: an aluminum implant for forming the p- well, and a n-type implant for forming the base of the PNP transistor.

Moreover, the fabrication of only PNP transistors does not require masking step 5.

The present invention provides, in addition to vertical NPN transistors, vertical PNP transistors rather than lateral PNP transistors. Generally, a vertical transistor is superior to a lateral transistor due to, among other reasons, better collection of carriers. Hence, a process providing complementary lateral PNP transistors and vertical NPN transistor may be suitable only for applications which are tolerant of the performance degradation imposed by the lateral transistors.

In the drawings, where like reference characters indicate like parts,
FIGURE 1 is a cross section of an integrated circuit structure illustrating a substrate upon which a doped epitaxial layer and an oxide layer are formed, and the oxide layer defined for the buried layer and P- tub of the NPN transistor;
FIGURE 2 is a subsequent cross section view after further definition of the oxide layer for a channel stopper for the NPN transistor, and a buried layer for the PNP transistor;
FIGURE 3 is a subsequent cross section view after definition of isolation islands;
FIGURE 4 is a subsequent cross section view after formation of field oxide;
FIGURE 5 is a subsequent cross section view after formation of a sink for the NPN transistor, and a ground for the PNP transistor;
FIGURE 6 is a subsequent cross section view after formation of a base for the NPN transistor, and a sink and base for the PNP transistor;
FIGURE 7 is a subsequent cross section view after poly definition and silicide formation; and
FIGURE 8 is a cross section view after an alternative poly definition and silicide formation process sequence.

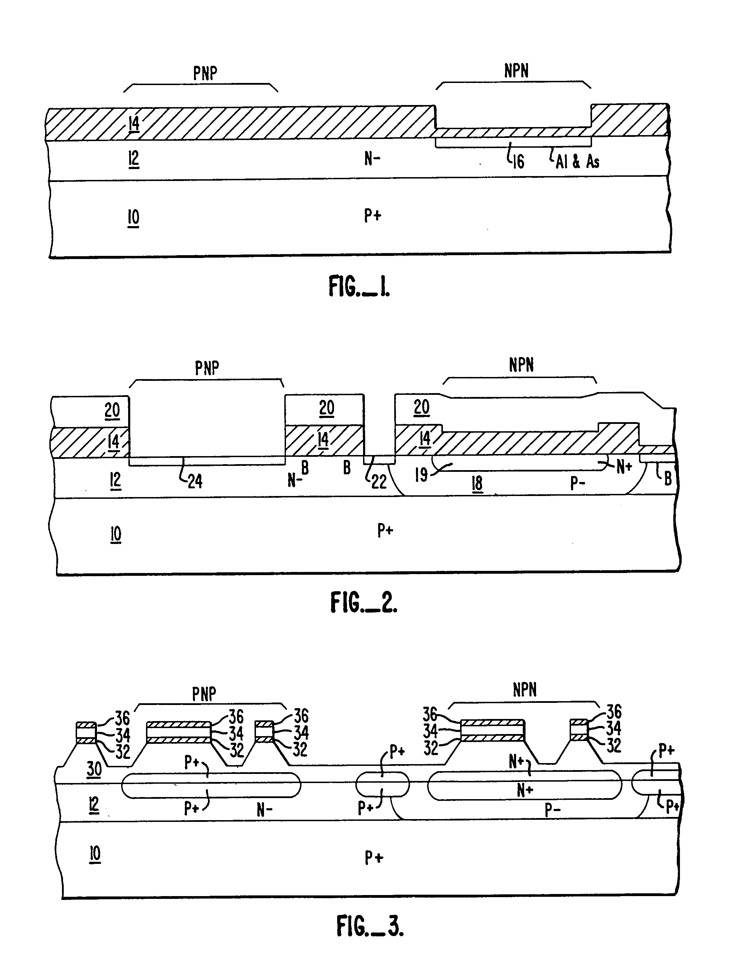

In fabricating the complementary vertical bipolar transistors of the present invention, one preferably selects as the starting material a silicon substrate 10 having a high conductivity. As will become apparent below, the high conductivity feature is desirable because the substrate will function as the ground tap for the NPN transistor. A suitable starting material is a p-type silicon wafer having the orientation <100> and a resistivity of about 0.1 ohm.m (0.001 ohm-centimeter). For purposes of the present invention, silicon substrate 10 is provided with a first n-type epitaxial layer 12 thereon; see Figure 1. An epitaxial layer 12 of thickness 5 microns and doped with phosphorus at a concentration of 1.10²¹ atoms/m³ (1x10¹⁵ atoms/cm³) is suitable

A p- tub and a buried layer for the NPN transistor are formed in the next process sequence; the resulting structure is shown in Figure 1. A thermal silicon dioxide layer 14 of about 5000 Angstroms in thickness is formed on the upper surface of the epitaxial layer 12. A layer of photoresist (not shown) is deposited and suitably patterned in a first masking step, followed by a plasma etch of the oxide over region 16 of the epitaxial layer 12. The resist is stripped, and a thin protective thermal oxide of about 10 nm (100 Angstroms) is grown over the epitaxial region 16. A fast diffusing p-type impurity such as aluminum and a slower diffusing n-type impurity such as arsenic are introduced into the epitaxial region 16 through the thin overlying oxide, under such conditions of dose, energy and anneal time so that a suitable dopant profile is achieved. A satisfactory anneal for the aluminum-arsenic implant is 1100 °C for one hour. The desired profile (refer to Figure 2) is a p- well 18 having a substantially uniform concentration of 2.10²¹ atoms/m³ (2x10¹⁵ atoms/cm³), which is formed by the quickly diffusing aluminum dopant. The slower arsenic dopant diffuses to a much lesser extent, as indicated by region 19. The arsenic implant is made, for example, at a dose in the range of 1.10¹⁹ to 1.10²⁰ ions/m² (1x10¹⁵ to 1x10¹⁶ ions/cm²) at an energy of 100 keV.

A channel stopper for the NPN transistor and the buried layer for the PNP transistor are formed in the next process sequence; the resulting structure is shown in Figure 2. A layer of photoresist 20 is deposited and suitably patterned in a second masking step, followed by a plasma etch of the oxide over epitaxial region 22 to accommodate formation of the channel stopper, and epitaxial region 24 to accommodate formation of the PNP transistor buried layer. A p-type dopant such as boron is introduced into the epitaxial regions 22 and 24. A suitable implant dose is 1.10¹⁹ ions/m² (1x10¹⁵ ions/cm²) at about 50 keV; a suitable anneal is at 1000 degrees C for thirty minutes.

Isolation islands are fabricated in the next process sequence; the resulting structure is shown in Figure 3. Photoresist 20 and oxide 14 are stripped, and an undoped epitaxial layer 30 is grown over n-type epitaxial layer 12 to a thickness of from one to two microns. Epitaxial layer 30 is oxidized, thereby forming an oxide layer 32 about 20 nm (200 Angstroms) thick on the surface. About 150 nm (1500 Angstroms) of nitride are deposited (layer 34) and oxidized at 1000 degrees C for 45 minutes to grow a thin oxide 36 on the upper surface of the nitride layer 34.

A layer of photoresist (not shown) is applied and suitably patterned in a third masking step (isolation mask), followed by an etching of the oxide-nitride-oxide layers 32, 34 and 36. The oxide layers 32 and 36 are etched using a 6:1 BOE etch or any suitable plasma etch. The nitride layer 34 is etched using a suitable plasma. Using the oxide-nitride-oxide 32-34-36 sandwich as a mask, the epitaxial layer 30 is etched in KOH to a depth of 600-700 nm (6000-7000 Angstroms) to form the isolation islands and sinks for the PNP and NPN transistors, as well as the ground contact (+5 volts) for the PNP transistor.

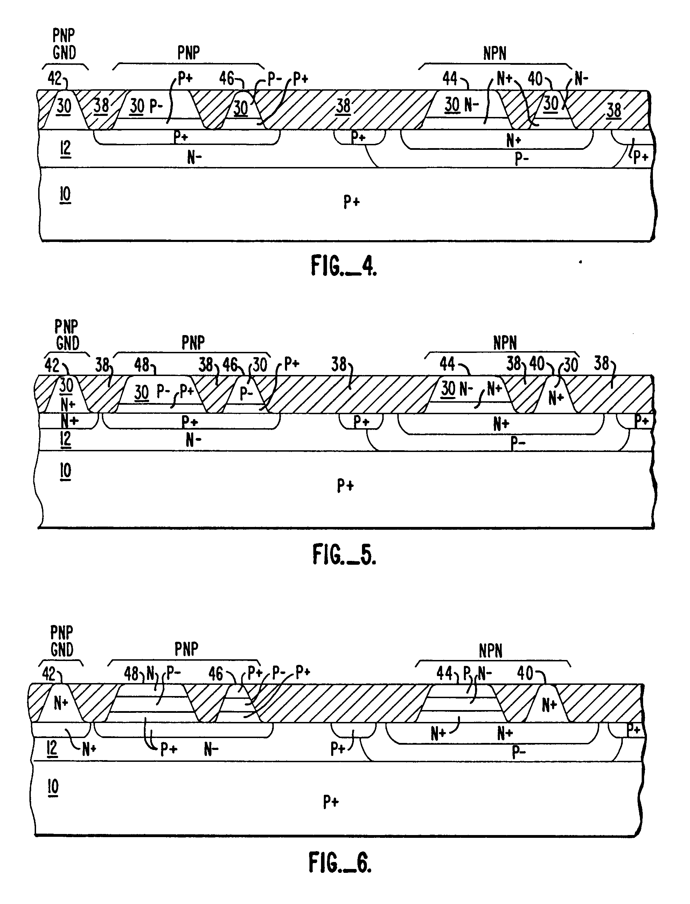

Field oxide 38 is grown and the wafer planarized; the resulting structure is shown in Figure 4. For example, the oxide may be grown at 1000 degrees C for 20 minutes at about 25 atmospheres to produce an oxide of suitable thickness. The remaining sections of layers 32, 34 and 36 are suitable stripped.

The isolation technique described herein is substantially similar to that taught in US-A-Number 3,648,125, issued March 7, 1972 to Peltzer, which is commonly known as the Isoplanar technique. Any resulting "bird's head" is removed and the structure planarized by any suitable technique; an example is taught in US-A-Number 4,539,744, issued September 10, 1985 to Burton, which hereby is incorporated herein by reference.

The sink of the NPN transistor and the ground of the PNP transistor are formed in the next process sequence; the resulting structure is shown in Figure 5. Photoresist is applied to the surface of the structure shown in Figure 4 and patterned in a fourth masking step to expose sink region 40 and PNP ground region 42. A suitable n-type dopant such as phosphorus is implanted at a dose of 1.10²⁰ ions/m² (1x10¹⁶ ions/cm²) with an energy of 150 keV, and the wafer is annealed at, for example, 1000 degrees for 30 minutes in a N₂ ambient.

The base of the NPN transistor is formed in the next process sequence; the sink for the PNP transistor also is completed at this time. A layer of photoresist (not shown) is deposited and suitably patterned in a fifth masking step to accommodate the implant of a suitable p-type dopant such as boron into the region 44 (Figure 5) of the NPN transistor to form a base, and into the sink region 46 (Figure 5) of the PNP transistor. Boron is implanted at a dose of from 5.10¹ to 5.10¹⁷ ions/m² (5x10¹² to 5x10¹³ ions/cm²) with an energy up to about 100 keV, and the wafer is annealed at, for example, 1000 degrees C for 30 minutes in a N₂ ambient. A NPN base width of between 100 and 400 nm (1000 and 4000 Angstroms) is satisfactory.

The base of the PNP transistor is formed in the next process sequence. A layer of photoresist (not shown) is deposited and suitably patterned in a sixth masking step to accommodate the implant of a suitable n-type dopant such as arsenic into the region 48 (Figure 5) of the PNP transistor to form a base. Arsenic is implanted at a dose of 5.10¹⁷ ions/m² (5x10¹³ ions/cm²) with an energy of 150 keV, and the wafer is annealed at, for example, 950 degrees C for 10 to 15 minutes in a N₂ ambient. A PNP base width of between 1000 and 2000 Angstroms is satisfactory.

The structure resulting from the fifth and sixth masking steps is shown in Figure 6.

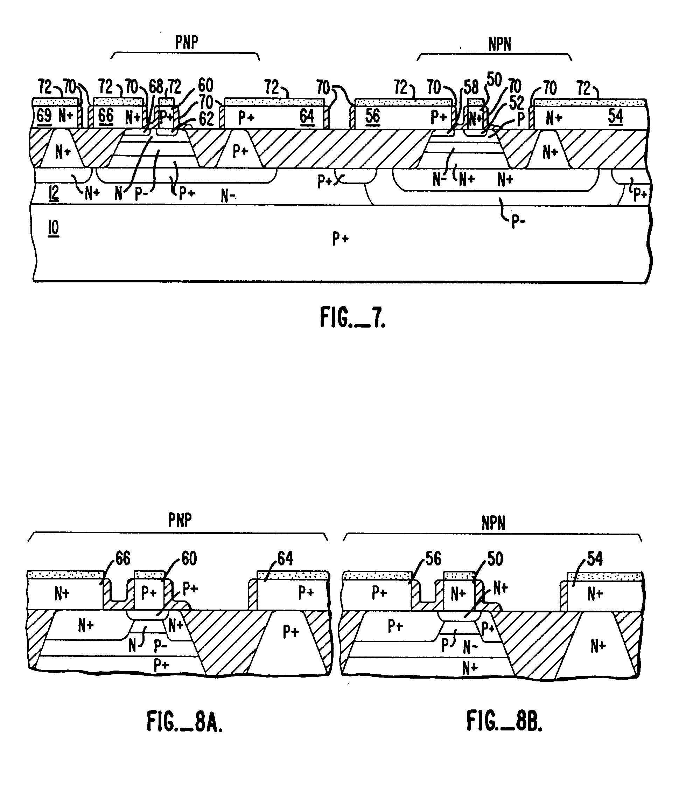

The seventh, eighth, ninth and tenth masking steps are provided for doping and patterning a polysilicon layer to form interconnections and emitters, substantially in accordance with US-A-4,609,568, issued September 2, 1986 to Koh et al., which hereby is incorporated herein by reference. A layer of polycrystalline silicon of desired thickness is deposited by, for example, chemical vapor deposition. Using well known photolithographic techniques in conjunction with diffusion or ion implantation processes, selected impurity types are introduced into selected regions of the polysilicon layer. In the seventh masking step, a suitable n-type implant is made for forming the emitter interconnect line 50, the emitter 52, and the collector interconnect line 54 of the NPN transistor, and the base interconnect line 66 and extrinsic base 68 of the PNP transistor. The implant for the ground interconnect line 69 of the PNP transistor also is made at this time. In the eighth masking step, a suitable p-type implant is made for forming the emitter interconnect line 60, the emitter 62, and the collector interconnect line 64 of the PNP transistor, and the base interconnect line 56 and extrinsic base 58 of the NPN transistor. Masking steps nine and ten implement a silicide exclusion technique for define resistors and diodes and patterning the polysilicon layer. The pattern and arrangement of the resulting doped regions is selected in accordance with the desired active and passive devices being fabricated. The order of the masking steps for the silicide exclusion technique taught in the aforementioned Koh et al. patent may be reversed if desired. The remaining silicon nitride is stripped and a silicide formed over the interconnect lines; a satisfactory technique is taught in US-A-4,567,058, issued January 28, 1986 to Koh. The resulting structure is shown in Figure 7.

The silicide exclusion technique specific to the present invention now is described in detail. About 100 nm (1000 Angstroms) of Si₃N₄ are deposited over a thin oxide overlying the polysilicon layer. The wafer is annealed at about 800 °C or 900 °C for 30 minutes to distribute the dopant in the polysilicon layer. A layer of photoresist (not shown) is deposited and suitably patterned in masking step 9 to define the polysilicon layer in a desired interconnect pattern for the NPN and PNP transistors. The resistors and diodes remain masked. The nitride, oxide and polysilicon are etched with suitable plasmas, and the residual resist is stripped in an O₂ plasma. Another layer of photoresist (not shown) is deposited and suitably patterned in masking step 10 to permit removal of the nitride and thin oxide, as described above, over the resistors and diodes. When the residual resist is stripped in an O₂ plasma etch, nitride remains only in those areas where silicide is to be formed. An anneal is performed at this time to diffuse dopants from the polysilicon lines 50, 54, 56, 60, 64, 66, and 69 into underlying epitaxial regions, thereby forming, for example, the emitter 52 and extrinsic base 58 of the NPN transistor, and the emitter 62 and extrinsic base 68 of the PNP transistor. An anneal temperature of 950 °C for 30 minutes is satisfactory. The structure is subject to a thermal oxidation at, for example, 850 °C to 1000 °C for from 10 to 60 minutes as appropriate to passivate all polysilicon and epitaxial silicon areas with oxide 70; silicide is to be excluded from these areas.

In one variation, the extrinsic bases for the NPN and PNP transistors are extended substantially in accordance with the teachings set forth in United States Patent Application Serial Number 834,926, filed February 28, 1986 in the name of Vora, which hereby is incorporated herein by reference. This variation results in a significantly lower base resistance, and hence improved transistor performance. Specifically, polysilicon definition masking step 9 is replaced by two masking steps 9A and 9B, which use separate polysilicon definition masks for the NPN and PNP transistors. As taught above, silicon nitride is deposited over a thin oxide overlying the polysilicon layer, and annealed. A layer of photoresist (not shown) is deposited and suitably patterned in masking step 9A to define the interconnect pattern for the NPN transistors. The PNP transistors, diodes, and resistors remain masked. The nitride and oxide, and then the polysilicon, are etched as described above, which exposes portions of region 44 about the NPN emitter interconnect line 50. An extrinsic NPN base implant is made using a p-type impurity such as boron. An implant of BF₂ at a dose of 4.10¹⁸ ions/m² (4 x 10¹⁴ ions/cm²) and an energy of 40 keV is satisfactory. The residual resist is stripped in an O₂ plasma. Another layer of photoresist (not shown) is deposited and suitably patterned in masking step 9B to define the interconnect pattern for the PNP transistors. The NPN transistors, diodes, and resistors remain masked. The nitride and oxide, and then the polysilicon, are etched as described above, which exposes portions of region 48 about the PNP emitter interconnect line 60. An extrinsic PNP base implant is made using a n-type impurity such as phosphorus; a dose of 1.10¹⁸ to 5.10¹⁸ ions/m² (1x10¹⁴ to 5x10¹⁴ ions/cm²) at an energy of from 40-80 keV is satisfactory. The residual resist is stripped in an O₂ plasma, and processing continues as described above with respect to masking step 10. The resulting structure is shown in relevant part in Figure 8 (expanded scale).

Additional masking steps are provided for forming contact holes (mask 11), patterning first metal (mask 12), forming via holes (mask 13), patterning second metal (mask 14), and furnishing scratch protection (mask 15). Suitable techniques are well known in the art.

While the invention has been described with reference to a particular embodiment, one will appreciate that the embodiment is illustrative only and that the invention is not intended to be limited to the particular embodiment. For example, although specific materials, doses, temperatures, thicknesses and periods have been described, these are set forth to enable a full understanding of the invention, not to limit the invention Moreover, one will appreciate that the performance of the transistors of the invention may be improved by providing additional structural features or alternative doping profiles, which in some cases will complicate the process with one or more additional masking steps. An example of this is the extension of the extrinsic bases of the NPN and PNP transistors taught above with reference to the Vora 834,926 application, which requires only a single additional masking step. Also, other interconnect techniques such as taught in United States Patent Application Serial Number 817,231, filed January 8, 1986 in the name of Vora et al. patents, may be used with the invention. Accordingly, these variations are contemplated herein and are to be considered within the scope of the present invention.

## Claims

1. A process for fabricating complementary vertical bipolar transistors on a semiconductor substrate (10) of a first conductivity type, comprising the steps of:
forming an epitaxial silicon layer (12) on said substrate (10),
forming a first epitaxial silicon island on the surface of said epitaxial layer (12) and underlaid by a buried layer (19) of an opposite conductivity type formed in a well (18) of the first conductivity type within said epitaxial silicon layer (12), said well being electrically integrated with said substrate;
forming a polysilicon emitter (52) transistor of a first type in said first epitaxial silicon island;
forming a second epitaxial silicon island underlaid by a buried layer of the first conductivity type on a region of said epitaxial silicon layer (12) of the opposite conductivity type; and
forming a polysilicon emitter (62) transistor of a second type in said second epitaxial silicon island, said transistor of the second type being complementary to said transistor of the first type.

2. A process as in claim 1, comprising the steps of:
forming a first epitaxial silicon layer (12) of an opposite conductivity type on said substrate;
introducing into a first region (16) of said first epitaxial layer a fast diffusing dopant of the first conductivity type to form said well (18), and a slower diffusing dopant of the opposite conductivity type to form said buried layer (19) ;
introducing into a second region of said first epitaxial layer a dopant of the first conductivity type to form a buried layer (24);
forming a second epitaxial silicon layer (30) on said first epitaxial layer;
forming said epitaxial silicon islands in said second epitaxial layer over said first region and said second region;
forming said polysilicon emitter (52) transistor of a first type (npn) in the epitaxial silicon island over said first region; and forming said polysilicon emitter (62) transistor of a second type (pnp) in the epitaxial silicon island over said second region.

3. A process as in claim 1 or 2, wherein said substrate (10) is of low resistivity.

4. A process as in claim 3, further comprising the step of doping said substrate to achieve said low resistivity.

5. A process as in claim 1, wherein said well (18) is a p-well having a substantially uniform aluminium concentration of 2x10¹⁵ atoms/cm³.

6. A process as in claim 4, wherein said fast diffusing dopant is aluminium, further comprising the step of achieving a p-well having a substantially uniform aluminium concentration of 2x10¹⁵ aluminium atoms/cm³ and electrically integrated with said substrate.

7. A process as in claim 6, further comprising the step of doping said substrate to achieve a resistivity of 0.001 ohm.centimeter.

8. A process as in claim 1 or 2, wherein said first conductivity type is p-type, said opposite conductivity type is n-type, said first transistor type is NPN, and said second transistor type is PNP.

9. A complementary vertical bipolar transistor structure comprising:
a semiconductor substrate (10) of a first conductivity type;
a first epitaxial silicon island defined on an epitaxial well (18) of the first conductivity type formed upon said substrate and electrically integrated therewith, said first epitaxial island being underlaid by a first buried layer (19) of the opposite conductivity type and having a polysilicon emitter (52) of the opposite conductivity type and a base region (44) of the first conductivity type extending between said first emitter and said first buried layer; and
a second epitaxial silicon island defined on an epitaxial region of the opposite conductivity type formed upon said substrate; said second island being underlaid by a second buried layer (24) of the first conductivity type and having a second polysilicon emitter (62) of the first conductivity type and a base region (48) of the opposite conductivity type extending between said second emitter and said second buried layer.

10. A complementary vertical bipolar transistor structure as in claim 9, comprising:
a first epitaxial layer (12) on said substrate (10), a first region (18) thereof being of the first conductivity type and electrically integrated with said substrate, and a second region thereof being of an opposite conductivity type;
said first epitaxial silicon island defined in a second epitaxial layer (30) over the first region of said first epitaxial layer, and
said second epitaxial silicon island defined in said second epitaxial layer over the second region of said first epitaxial layer.

11. A structure as in claim 9 or 10, wherein said substrate (10) is highly conductive.

12. A structure as in claim 9 or 10, wherein said epitaxial region of the first conductivity type is a p-well (18).

13. A structure as in claim 12, wherein said p-well has an aluminium concentration of 2x10¹⁵ atoms/cm³ and said substrate has a resistivity of 0.001 ohm.cm.

14. A structure as in claim 9 or 10, wherein said first conductivity type is p-type and said opposite conductivity type is n-type.

## Patentansprüche

1. Ein Verfahren für die Herstellung komplementärer vertikaler bipolarer Transistoren auf einem Halbleitersubstrat (10) eines ersten Leitfähigkeitstyps, umfassend die Schritte:
Bilden einer Epitaxialsiliciumschicht (12) auf dem Substrat (10);
Bilden einer ersten Epitaxialsiliciuminsel auf der Oberfläche der Epitaxialschicht (12) und unterlegt von einer vergrabenen Schicht (19) eines entgegengesetzten Leitfähigkeitstyps, gebildet in einer Wanne (18) des ersten Leitfähigkeitstyps innerhalb der genannten Epitaxialsiliciumschicht (12), wobei die Wanne elektrisch mit dem Substrat integriert ist;
Bilden eines Transistors eines ersten Typs mit Polysiliciumemitter in der genannten ersten Epitaxialsiliciuminsel;
Bilden einer zweiten Epitaxialsiliciuminsel, unterlegt von einer vergrabenen Schicht des ersten Leitfähigkeitstyps, auf einem Bereich der genannten Epitaxialsiliciumschicht (12) vom entgegengesetzten Leitfähigkeitstyp; und
Bilden eines Transistors mit Polysiliciumemitter (62) eines zweiten Typs in der genannten zweiten Epitaxialsiliciuminsel, wobei der genannte Transistor des zweiten Typs komplementär zu dem genannten Transistor des ersten Typs ist.

2. Ein Verfahren nach Anspruch 1, umfassend die Schritte:
Bilden einer ersten Epitaxialsiliciumschicht (12) eines entgegengesetzten Leitfähigkeitstyps auf dem Substrat;
Einführen in einen ersten Bereich (16) der genannten ersten Epitaxialschicht eines schnell diffundierenden Dotierungsmittels des ersten Leitfähigkeitstyps zum Bilden der Wanne (18) und eines langsamer diffundierenden Dotierungsmittels vom entgegengesetzten Leitfähigkeitstyp zum Bilden der vergrabenen Schicht (19);
Einführen, in einen zweiten Bereich der genannten ersten Epitaxialschicht, eines Dotierungsmittels des ersten Leitfähigkeitstyps zum Bilden einer vergrabenen Schicht (24);
Bilden einer zweiten Epitaxialsiliumschicht (30) auf der genannten ersten Epitaxialschicht;
Bilden der Epitaxialsiliciuminseln in der zweiten Epitaxialschicht über dem ersten Bereich und dem zweiten Bereich;
Bilden des Transistors mit Polysiliciumemitter (52) eines ersten Typs (NPN) in der Epitaxialsiliciuminsel über dem ersten Bereich und Bilden des Transistors mit Polysiliciumemitter (62) eines zweiten Typs (PNP) in der Epitaxialsiliciuminsel über dem zweiten Bereich.

3. Ein Verfahren nach Anspruch 1 oder 2, bei dem das Substrat (10) von niedrigem spezifischen Widerstand ist.

4. Ein Verfahren nach Anspruch 3, ferner umfassend den Schritt der Dotierung des Substrats zum Erreichen des genannten niedrigen spezifischen Widerstandes.

5. Ein Verfahren nach Anspruch 1, bei dem die Wanne (18) eine p-Wanne ist mit einer im wesentlichen gleichförmigen Aluminiumkonzentration von 2 x 10¹⁵ Atomen/cm³.

6. Ein Verfahren nach Anspruch 4, bei dem das schnell diffundierende Dotierungsmittel Aluminium ist, ferner umfassend den Schritt der Erzielung einer p-Wanne mit einer im wesentlichen gleichförmigen Aluminiumkonzentration von 2 x 10¹⁵ Aluminiumatomen/cm³ und elektrisch integriert mit dem Substrat.

7. Ein Verfahren nach Anspruch 6, ferner umfassend den Schritt der Dotierung des Substrats zum Erzielen eines spezifischen Widerstandes von 0,001 Ohm cm.

8. Ein Verfahren nach Anspruch 1 oder 2, bei dem der erste Leitfähigkeitstyp p-Typ ist, der entgegengesetzte Leitfähigkeitstyp n-Typ ist, der erste Transistor ein NPN- und der zweite Transistor ein PNP-Transistor sind.

9. Eine komplementäre vertikale bipolare Transistorstruktur, umfassend:
ein Halbleitersubstrat (10) eines ersten Leitfähigkeitstyps;
eine erste Epitaxialsiliciuminsel, definiert auf einer Epitaxialwanne (18) des ersten Leitfähigkeitstyp, gebildet auf dem Substrat und elektrisch integriert mit diesem, welche erste Epitaxialinsel von einer ersten vergrabenen Schicht (19) des entgegengesetzten Leitfähigkeitstyps unterlegt ist und einen Polysiliciumemitter (52) vom entgegengesetzten Leitfähigkeitstyp sowie einen Basisbereich (44) des ersten Leitfähigkeitstyps aufweist, sich erstreckend zwischen dem ersten Emitter und der ersten vergrabenen Schicht; und
eine zweite Epitaxialsiliciuminsel, definiert auf einem Epitaxialbereich entgegengesetzten Leitfähigkeitstyps, ausgebildet auf dem Substrat, welche zweite Insel unterlegt ist mit einer zweiten vergrabenen Schicht (24) des ersten Leitfähigkeitstyps, und einen zweiten Polysiliciumemitter (62) des ersten Leitfähigkeitstyps sowie einen Basisbereich (48) des entgegengesetzten Leitfähigkeitstyps aufweist, sich erstreckend zwischen dem zweiten Emitter und der zweiten vergrabenen Schicht.

10. Eine komplementäre vertikale bipolare Transistorstruktur nach Anspruch 9, umfassend:
eine erste Epitaxialschicht (12) auf dem Substrat (10), wobei ein erster Bereich (18) vom ersten Leitfähigkeitstyp und elektrisch mit dem Substrat integriert ist und ein zweiter Bereich vom entgegengesetzten Leitfähigkeitstyp ist, wobei die erste Epitaxialsiliciuminsel in einer zweiten Epitaxialschicht (30) über dem ersten Bereich der ersten Epitaxialschicht definiert ist und die zweite Epitaxialsiliciuminsel in der zweiten Epitaxialschicht über dem zweiten Bereich der ersten Epitaxialschicht definiert ist.

11. Eine Struktur nach Anspruch 9 oder 10, bei der das Substrat (10) hochleitend ist.

12. Eine Struktur nach Anspruch 9 oder 10, bei der der Epitaxialbereich des ersten Leitfähigkeitstyps eine p-Wanne (18) ist.

13. Eine Struktur nach Anspruch 12, bei der die p-Wanne eine Aluminiumkonzentration von 2 x 10¹⁵ Atomen/cm³ aufweist und das Substrat einen spezifischen Widerstand von 0,001 Ohm cm besitzt.

14. Eine Struktur nach Anspruch 9 oder 10, bei der der erste Leitfähigkeitstyp p-Typ ist und der entgegengesesetzte Leitfähigkeitstyp n-Typ ist.

## Revendications

1. Procédé de fabrication de transistors bipolaires verticaux complémentaires sur un substrat semi-conducteur (10) d'un premier type de conductivité comprenant les étapes consistant à :
former une couche de silicium épitaxiale (12) sur ledit substrat (10);
former un premier îlot de silicium épitaxial sur la surface de ladite couche épitaxiale (12) et recouvrant une couche enterrée (19) d'un type de conductivité opposée formée dans un puits (18) du premier type de conductivité à l'intérieur de ladite couche de silicium épitaxiale (12), ledit puits étant intégré électriquement audit substrat;
former un transistor à émetteur en polysilicium (52) d'un premier type dans ledit premier îlot de silicium épitaxial;
former un deuxième îlot de silicium épitaxial recouvrant une couche enterrée d'un premier type de conductivité sur une région de ladite couche de silicium épitaxiale (12) de type de conductivité opposée; et
former un transistor à émetteur en polysilicium (62) d'un second type dans ledit deuxième îlot de silicium épitaxial, ledit transistor de second type étant complémentaire audit transistor de premier type.

2. Procédé selon la revendication 1, comprenant les étapes consistant à :
former une première couche de silicium épitaxiale (12) d'un type de conductivité opposée sur ledit substrat;
introduire dans une première région (16) de ladite première couche épitaxiale un dopant du premier type de conductivité diffusant rapidement pour former ledit puits (18) et un dopant du type de conductivité opposé diffusant plus lentement pour former ladite couche enterrée (19);
introduire dans une deuxième région de ladite première couche épitaxiale un dopant du premier type de conductivité pour former une couche enterrée (24);
former une deuxième couche de silicium épitaxial (30) sur ladite première couche épitaxiale;
former lesdits îlots de silicium épitaxial dans ladite deuxième couche épitaxiale sur ladite première région et ladite deuxième région;
former ledit transistor à émetteur en polysilicium (52) d'un premier type (npn) dans l'îlot de silicium épitaxial sur ladite première région; et former ledit transistor à émetteur en polysilicium (62) d'un deuxième type (pnp) dans l'îlot de silicium épitaxial sur ladite deuxième région.

3. Procédé selon la revendication 1 ou 2 dans lequel ledit substrat 10 présente une faible résistivité.

4. Procédé selon la revendication 3 comprenant en outre l'étape consistant à doper ledit substrat pour réaliser ladite faible résistivité.

5. Procédé selon la revendication 1 dans lequel ledit puits (18) est un puits p ayant une concentration en aluminium sensiblement uniforme de 2x10¹⁵ atomes/cm³.

6. Procédé selon la revendication 4 dans lequel ledit dopant diffusant rapidement est l'aluminium, comprenant en outre l'étape consistant a réaliser un puits p ayant une concentration d'aluminium sensiblement uniforme de 2x1015 atomes d'aluminium/cm3 et qui est électriquement intégré avec ledit substrat.

7. Procédé selon la revendication 6 comprenant en outre l'étape consistant à doper ledit substrat pour réaliser une résistivité de 0,001 ohm.centimètre.

8. Procédé selon la revendication 1 ou 2 dans lequel ledit premier type de conductivité est le type p, ledit type de conductivité opposé est le type n, ledit premier type de transistor est NPN et ledit deuxième type de transistor est PNP.

9. Structure de transistors bipolaires verticaux complémentaires comprenant :
un substrat semi-conducteur (10) d'un premier type de conductivité;
un premier îlot de silicium épitaxial défini sur un puits épitaxial (18) du premier type de conductivité formé sur ledit substrat et électriquement intégré avec celui-ci, ledit premier îlot épitaxial recouvrant une première couche enterrée (19) du type de conductivité opposée et ayant un émetteur en polysilicium (52) du type de conductivité opposée et une région de base (44) du premier type de conductivité s'étendant entre ledit premier émetteur et ladite première couche enterrée; et
un deuxième îlot de silicium épitaxial défini sur une région épitaxiale du type de conductivité opposée formé sur ledit substrat; ledit deuxième îlot recouvrant une deuxième couche enterrée (24) du premier type de conductivité et ayant un deuxième émetteur en polysilicium (62) du premier type de conductivité et une région de base (48) du type de conductivité opposée et s'étendant entre ledit deuxième émetteur et ladite deuxième couche enterrée.

10. Structure de transistors bipolaires verticaux complémentaires selon la revendication 9 comprenant :
une première couche épitaxiale (12) sur ledit substrat (10), une première région (18) de celui étant du premier type de conductivité et électriquement intégrée avec ledit substrat, et une deuxième région de celui-ci étant d'un type de conductivité opposé;
ledit premier îlot de silicium épitaxial défini dans une deuxième couche épitaxiale (30) sur la première région de ladite première couche épitaxiale et
ledit deuxième îlot de silicium épitaxial défini dans ladite deuxième couche épitaxiale sur la deuxième région de ladite première couche épitaxiale.

11. Structure selon la revendication 9 ou 10 dans lequel ledit substrat (10) est très conducteur.

12. Structure selon la revendication 9 ou 10 dans lequel ladite région épitaxiale du premier type de conductivité est un puits p (18).

13. Structure selon la revendication 12 dans lequel ledit puits p présente une concentration en aluminium de 2x10¹⁵ atomes/cm³ et ledit substrat présente une résistivité de 0,001 ohm.cm.

14. Structure selon la revendication 9 ou 10 dans laquelle ledit premier type de conductivité est le type p et ledit type de conductivité opposé est le type n.
